# EUROPEAN PATENT SPECIFICATION

(11) **EP 0 288 099 B1**
(45) Date of publication and mention of the grant of the patent: **14.07.1993**
(21) Application number: 88200581.2
(22) Date of filing: 28.03.1988
(51) Int. Cl.: G01R 27/22

(54) **Method and device for measuring the conductivity of a liquid, with which the influence of polarisation is counteracted**
Verfahren und Anordnung für das Messen des Leitvermögens einer Flüssigkeit, wobei dem Einfluss der Polarisation entgegengewirkt wird
Méthode et appareil pour la mesure de la conductibilité d'un liquide, dans lequel l'influence de la polarisation est contrecarrée

(30) Priority: 30.03.1987 NL 8700744
(43) Date of publication of application: 26.10.1988
(73) Proprietor: Yokogawa Europe B.V., NL-3812 RA Amersfoort (NL)
(72) Inventor: Beijk, Jozeph Michael, Ir., NL-3829 AA Hooglanderveen (NL)
(74) Representative: de Bruijn, Leendert C.

(56) References cited:
- EP-A- 0 010 823
- DE-A- 3 517 772
- FR-A- 2 581 196

## Description

The invention relates to method for measuring the conductivity of a liquid, in which two electrodes are put in contact with the liquid and a block pulse of voltage or current of predetermined polarity is applied to the electrodes, the current flowing between the electrodes or the voltage between the electrodes being sampled at three or more different time points during said block pulse, the conductivity of the liquid being determined on base of the sampled values of current or voltage at the time points.

It is known that with measurement of the conductivity the polarisation, which can occur at the electrodes may have a disturbing influence. This influence is already restricted in a considerable degree by using a voltage or current of alternating polarity in comparison with the use of d.c. voltage or current. Nevertheless the polarisation remains a factor, which may influence the measuring result that is obtained from the quotient of the current and the voltage between the electrodes.

It is also known, that the influence of polarisation decreases with higher frequencies, because the polarisation in the form of a layer of charge carriers at the surface of the electrode and immediately outside it may be built up gradually during current passage in one direction. In first approximation the development of voltage and current in a portion in which polarisation plays a part is comparable to the development of these quantities in a condensor, in which the thickness of the dielectrical layer changes during the formation of the polarisation. For these reasons it is extremely difficult to deduce from the measured current and voltage, which part of the voltage has to be attributed to the resistance of the liquid and which part to the polarization.

The solution to increase the frequency so far, that the polarisation does not play a part anymore, is, however, also less attractive. This is to be attributed to it, that with higher frequencies parasitical capacities have an increasing influence and that this influence, for instance when measuring relatively high resistances of badly conducting liquids forms a disturbing factor for the measurement.

A method and device as described in the first paragraph of this specification is known from DE-A-3 517 772, in which the polarisation is discarded by sampling the voltage values occurring between two electrodes contacting the liquid to be measured during a rectangular unidirectional current pulse. From a plurality of sample values the first and second derivatives are deduced. The voltage at which the first derivative is zero is considered to be the voltage corresponding to the current when no capacitive or polarisation effects occur. A second possibility is to select the voltage at which the first derivative changes sign, which means that the second derivative is zero.

Such a system needs a rather important number of samples in order to be sure that the right voltage value is selected. As a matter of fact the voltage will always rise, first by reason of reversing electrical charges and later on because of the increase of the polarisation. Therefor a value zero of the first derivative of the voltage will only occur approximately. Also the increase or decrease of the first derivative will be very small, so that the point where it changes sign cannot easily and reliably be ascertained with a high accuracy. The relative important number of samples to be taken in each current pulse induces a limit for either the accuracy (in case of a rather restricted number of samples in a current pulse) or the measuring rate (because of the finite time necessary to take a sample).

Further the measuring rate of this known system is strongly decreased because of the presence of a rest period between successive current pulses.

The invention aims to provide a method which is devoid of these restrictions and allows for an accurate measurement at a high measuring rate.

These aims are obtained with the method of claim 1.

Such a method does not only allow for quick and accurate measuring the conductivity, but also of the imaginary part of the impedance, which, as is well known, may be important for determining a.c. conductivity, especially at high frequencies.

In this respect it is pointed to FR-A-2 581 196 in which a device for measuring the resistivity of dielectric liquids has been shown in which device the transistory portions of the block voltage are removed, which portions are due to the parasitary capacities. This is in contradistinction with the invention in which sample values in the said transistory portions are welcome to be used in the processor.

According to a further elaboration of the invention it is provided that the block pulse is the positive or negative half of a symmetrical rectangular a.c. voltage or current. With this embodiment of the invention a double voltage or current change is obtained at the beginning of the block pulse. This leads to an increase of the deviation from the equilibrium condition, which is favourable, because the differences between sample values are increased.

According to still a further elaboration of the invention it is provided that the frequency of the a.c. voltage or current is increased with a higher value of the said imaginary part or a greater difference between sample values at predetermined time points. This feature enables always to work under favourable conditions, because a too high imaginary portion would impair the accuracy of the measurement of the resistive portion.

The invention further encompasses a device as defined in claim 4 and the improvement thereof defined in claim 5.

The invention in the following is further elucidated by means of the drawing, in which:
Figure 1 schematically shows the development of voltage and current between the electrodes; and
Figure 2 shows a simplified scheme of a device for applying the invention.

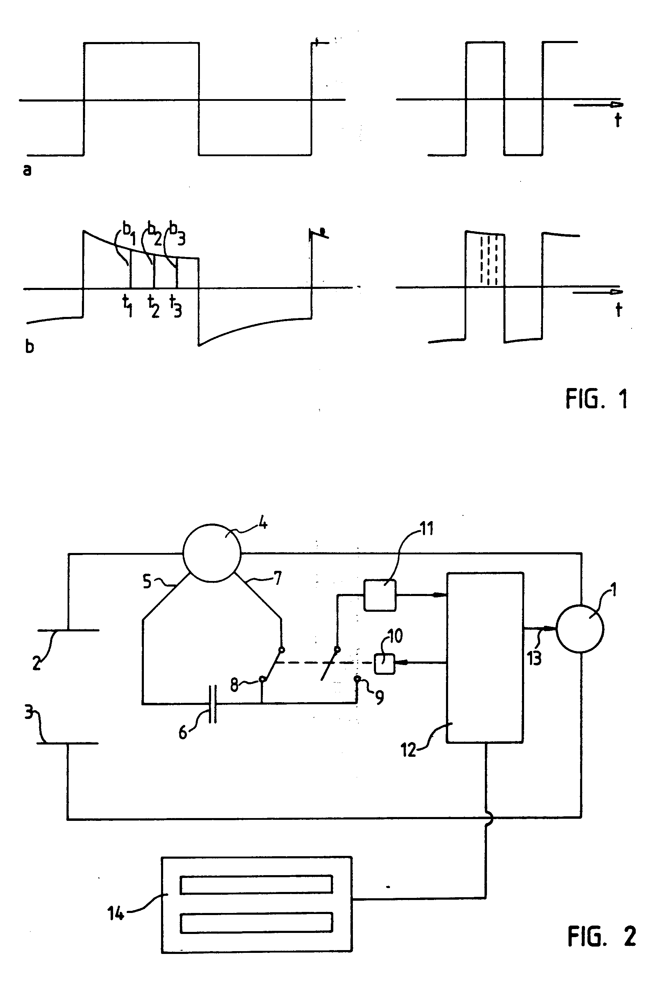

In fig. 1 the line a indicates the course of the voltage from the voltage source. This source is a generator for a symmetrical block voltage, which at the left side of fig. 1 has been shown with a relatively low frequency and at the right side with a higher frequency.

The curve b indicates the course of the current. When current flows in a predetermined direction charges come to existence at the transfer between the electrodes and the liquid by the hindrance to the current passage caused by polarisation. By changing the direction of the voltage or the polarity these accumulated charges cooperate with the applied voltage to give a relatively large current, which, however, after this decreases exponentially, to be inverted with the following polarity change of the voltage in a large current of opposite direction.

In fig. 1 has been indicated that at the time points t₁, t₂ and t₃ the current value is determined. This happens with a sampling device known per se, which for instance charges a condensor to a voltage, which is proportional the current. At the moment t₁ the connection with the condensor is then interrupted and the voltage memorized in the condensor is fed to a processor via a suitable circuit, preferably after digitalisation. The same is repeated at the time points t₂ and t₃.

In the shown embodiment t₁ is at 40% of the period of positive voltage and current; t₂ at 60% and t₃ at 80%. These values are solely chosen by way of elucidation. With a value, which is very near to the voltage change the possibility will occur, that the fast change of the current has caused unsufficient time to charge the condensor or another sampling element with sufficient accuracy, wherewith with sampling at a time point preceding shortly the voltage change the differences of the measured current values are very small. The time points t₁, t₂ and t₃ are for instance obtained by dividing by ten the period of the source delivering the voltage a and to carry out a sampling at the beginning of the fourth, sixth and eigth fraction.

In the right part of fig. 1 the same quantities are indicated, but now for a higher frequency. With a higher frequency the influence of the polarisation becomes considerably smaller and the measured current values are mainly determined by the resistance of the liquid between the electrodes, if a determined voltage is applied to the electrodes. The invention is based on it, that according to a first aspect from the differences between the values b₁, b₂ and b₃ it is deduced how large the influence of the polarisation is. When the meter is used for a liquid of considerably deviating specific conductivity also the currents with the same voltage may differ considerably. In that case it may be considered not to determine the differences between b₁, b₂ and b₃ but their quotient. From these differences or quotients it then can be ascertained that the deviation from a constant current course, which would correspond to lack of polarisation, has an undesired large value. In that case the frequency is increased and, as is visible in fig. 1, in that instance the influence of the polarisation is considerably smaller.

However, the invention has the advantage that always one can measure with the lowest frequency at which the polarisation remains between acceptable limits.

In the embodiment of fig. 1 a symmetrical block voltage has been indicated as feeding of the electrodes. It will, however, be clear, that also with other shapes of a voltage with alternating polarity the polarisation influences the momentary current, to wit in that sense, that the current always is increased by the polarisation immediately after a voltage change and is decreased immediately before a voltage change. In that way a sinus voltage, which is sampled symmetrically with respect to the centre of a half period will always give a higher current value at a moment preceding this centre than one following to it.

In fig. 2 an embodiment of a device for applying the invention has schematically been indicated.

A voltage generator 1 is connected to electrodes 2 and 3. In the connection between the generator 1 and the electrodes 2 a current meter 4 has been inserted which has two outputs over which a voltage is present, which is proportional to the current in circuit 1,2,3. The output 5 of the current meter 4 is connected directly to a condensor 6 and the other output 7 by means of a contact 8. This contact is coupled to a contact 9, such that when contact 8 is open contact 9 is closed and vice versa. The contacts 8 and 9 are served by a control member 10. The value of the voltage on the condensor 6 which is taken by means of contact 9, is fed to a digitalization device 11, which is connected to a processor 12. This processor has a memory, in which comparitive values have been entered for the quotients of voltage values successively taken from the condensor 6 and is adapted to control the frequency of the generator 1 by means of an output 13 after comparing these quotients with the fixed values.

Further the processor 12 may be provided with calculating means to determine the resistance factor and the capacity factor from at least three current sample values taken in one period of the same voltage in the presumption that the course of the current varies exponentially with the time. This presumption generally is sufficiently accurate to come to determining the resistance component of the impedance between the electrodes 2 and 3.

Then it is also possible to calculate the capacitive component, which is a measure for the polarisation. These values can be displayed for instance on a display device 14.

The invention also enables to determine the resistance of the liquid body between the electrodes 2 and 3 from the voltage of the generator 1 and the current measured between the electrodes 2 and 3. This value can then be compared to the resistance quotient of the impedance between the electrodes 2 and 3 from which also a measure for the polarisation follows. It is also possible by this comparison to make sure that no so large differences occur, that the measurement has become unreliable, for instance by gas forming on one of the electrodes or a serious soiling of it.

Of course fig. 2 is only a schematical indication of a device according to the invention and especially the elements 8, 9 and 10 can be formed by electronic switching means. Also reference 1 may be a current source, which causes a predetermined current to flow between the electrodes 2 and 3 and reference 4 may be a meter for determining the voltage between electrodes 2 and 3.

Further source 1 may give a voltage or current of arbitrary shape provided that current and voltage are known or measured at the same moments during a period of the same polarity.

Also the frequency control issuing from the processor 12 and indicated with connection 13 can be realized in many different ways and it is even possible to carry out the generator 1 as a trigger circuit and to have the processor 12 active to trigger and activate the switching device 10. If desired the output voltage of generator 11 also can be adjusted on base of the measured resistance.

Finally the display device 14 may be of each desired type.

## Claims

1. Method for measuring the conductivity of a liquid, in which two electrodes (2,3) are put in contact with the liquid and a block pulse (a) of voltage or current of predetermined polarity is applied to the electrodes, the current flowing between the electrodes or the voltage between the electrodes being sampled at three or more different time points (t₁,t₂,t₃) during said block pulse, the conductivity of the liquid being determined on base of the sampled values of current or voltage at the time points, characterized in that from said three or more sample values, the exponential function of the current or voltage is calculated, from which function the resistance and the imaginary part of the impedance of the liquid body between electrodes is determined.

2. Method according to claim 1, characterized in that the block pulse (a) is the positive or negative half of a symmetrical rectangular a.c. voltage or current.

3. Method according to claim 2, characterized in that the frequency of the a.c. voltage or current is increased with a higher value of the imaginary part or a greater difference between sample values at predetermined time points.

4. Device for measuring the conductivity of a liquid provided with a source (1) of a block voltage or current (a), which source is connected to a circuit connectable to electrodes (2,3) contacting a liquid, a meter (4) for measuring the current or the voltage between the electrodes, a sampling device (6,7,8,9,10) adapted to sample repeatedly the current or the voltage value in a period of the block voltage or current and a processor which is connected to the sampling device for receiving and processing the sample values, characterized in that the processor is adapted to derive an exponential function from at least three sample values and to determine the resistance and the imaginary part of the impedance between the electrodes.

5. Device according to claim 4, characterized in that the frequency of the said source is adjustable and in that the processor is adapted to adjust said source to a higher frequency with a higher value of the said imaginary part of the impedance.

## Patentansprüche

1. Verfahren zum Messen der Leitfähigkeit einer Flüssigkeit, bei welchem zwei Elektroden (2,3) in Kontakt mit der Flüssigkeit gebracht werden und ein Rechteckpuls (a) in der Spannung oder im Strom mit vorbestimmter Polarität an die Elektroden angelegt wird, wobei der Strom, der zwischen den Elektroden fließt, oder die spannung zwischen den Elektroden an drei oder mehr verschiedenen Zeitpunkten (t₁, t₂, t₃) während des Rechteckpulses abgetastet wird, wobei die Leitfähigkeit der Flüssigkeit auf der Grundlage der abgetasteten Strom- oder Spannungswerte an den Zeitpunkten bestimmt wird, dadurch gekennzeichnet, daß aus den drei oder mehr Abtastwerten die Exponentialfunktion des Stroms oder der Spannung berechnet wird, aus der der Widerstand und der Imaginärteil der Impedanz des Flüssigkeitskörpers zwischen den Elektroden bestimmt werden.

2. Verfahren nach Anspruch 1, dadurch gekennzeichnet, daß der Rechteckpuls (a) die positive oder negative Hälfte einer symmetrischen Rechteck-Wechselspannung oder eines symmetrischen Rechteck-Wechselstroms ist.

3. Verfahren nach Anspruch 2, dadurch gekennzeichnet, daß die Frequenz der Wechselspannung oder des Wechselstroms mit einem größeren Wert des Imaginärteils oder einer größeren Differenz zwischen Abtastwerten an vorbestimmten Zeitpunkten erhöht wird.

4. Vorrichtung zum Messen der Leitfähigkeit einer Flüssigkeit, die eine Quelle (1) für eine Rechteckspannung oder einen Rechteckstrom (a), welche mit einem Schaltkreis verbunden ist, der mit in Kontakt mit einer Flüssigkeit stehenden Elektroden (2, 3) verbunden werden kann, ein Meßgerät (4) zum Messen des Stroms oder der Spannung zwischen den Elektroden, eine Abtastwertaufnahmeeinrichtung (6, 7, 8, 9, 10), die dafür eingerichtet ist, den Wert des Stroms oder der Spannung in einer Periode der Rechteckspannung oder des Rechteckstroms wiederholt abzutasten, und einen Prozessor, der mit der Abtastwertaufnahmeeinrichtung verbunden ist, zum Aufnehmen und Verarbeiten der Abtastwerte enthält, dadurch gekennzeichnet, dass der Prozessor dafür eingerichtet ist, eine Exponentialfunktion aus mindestens drei Abtastwerten abzuleiten und den Widerstand und den Imaginärteil der Impedanz zwischen den Elektroden zu bestimmen.

5. Vorrichtung nach Anspruch 4, dadurch gekennzeichnet, dass die Frequenz der Quelle einstellbar ist und dass der Prozessor dafür eingerichtet ist, die Quelle auf eine höhere Frequenz mit einem höheren Wert des Imaginärteils der Impedanz einzustellen.

## Revendications

1. Procédé de mesure de la conductivité d'un liquide, selon lequel deux électrodes (2, 3) sont mises en contact avec le liquide et une impulsion rectangulaire (a) de tension ou de courant de polarité prédéterminée est appliquée sur les électrodes, le courant s'écoulant entre les électrodes ou bien la tension entre les électrodes étant échantillonné à trois instants différents ou plus (t1, t2, t3) pendant ladite impulsion rectangulaire, la conductivité du liquide étant déterminée sur la base des valeurs échantillonnées de courant ou de tension auxdits instants, caractérisé en ce que la fonction exponentielle du courant ou de la tension est calculée à partir des trois valeurs d'échantillonnage ou plus, la résistance et la partie imaginaire de l'impédance du corps liquide entre les électrodes étant déterminées à partir de cette fonction.

2. Procédé selon la revendication 1, caractérisé en ce que l'impulsion de blocage (a) est la moitié positive ou négative d'une tension à courant alternatif ou d'un courant alternatif rectangulaire symétrique.

3. Procédé selon la revendication 2, caractérisé en ce que la fréquence de la tension à courant alternatif ou su courant alternatif est augmentée avec une valeur plus élevée de la partie imaginaire ou une différence plus grande entre les valeurs d'échantillonnage à des instants prédéterminés.

4. Dispositif de mesure de la conductivité d'un liquide pourvu d'une source (1) de tension ou de courant rectangulaire (a), laquelle source est reliés à un circuit pouvant être relié aux électrodes (2, 3) en contact avec un liquide, un dispositif de mesure (4) destiné à mesurer le courant ou la tension entre les électrodes, un dispositif d'échantillonnage (6, 7, 8, 9, 10) prévu pour échantillonner de façon répétée la valeur de courant ou de tension au cours d'une période de la tension ou du courant rectangulaire et un dispositif de traitement qui est relié au dispositif d'échantillonnage afin de recevoir et traiter les valeurs d'échantillonnage, caractérisé en ce que le dispositif de traitement est arrangé pour dériver une fonction exponentielle d'au moins trois valeurs d'échantillonnage et pour déterminer la résistance et la partie imaginaire de l'impédance entre les électrodes.

5. Dispositif selon la revendication 4, caractérisé en ce que la fréquence de ladite source est réglable et en ce que le dispositif de traitement est arrangé pour ajuster ladite source à une fréquence plus élevée avec une valeur plus élevés de ladite partie imaginaire de l'impédance.
